# EUROPEAN PATENT APPLICATION

(11) **EP 4 375 867 A1**
(43) Date of publication of application: **29.05.2024**
(21) Application number: 23211509.7
(22) Date of filing: 22.11.2023
(51) Int. Cl.: G06F 30/12, G06F 30/18, H04L 41/14, H04L 41/22

(54) **USER INTERFACE-BASED DATA CENTER FABRIC DESIGN**

(30) Priority: 25.11.2022 IN 202241067869; 29.09.2023 US 202318478521
(71) Applicant: Juniper Networks, Inc., Sunnyvale, CA 94089 (US)
(72) Inventor: JOSHI, Mansi, Sunnyvale, 94089 (US); HUANG, Eric, Sunnyvale, 94089 (US); VAJRAPU, Venkata Rama Pradeep Kumar, Sunnyvale, 94089 (US); GUPTA, Vidushi, Sunnyvale, 94089 (US); NEWHOUSE, Travis Gregory, Sunnyvale, 94089 (US); GAO, Wei, Sunnyvale, 94089 (US); WESTBROOK, James Worth, Sunnyvale, 94089 (US)
(74) Representative: D Young & Co LLP

(57) **Abstract**

Techniques are described by which a fabric designer system provides a user interface (UI) to enable a user to design a data center fabric. For example, a fabric designer system comprises processor(s) and a memory comprising instructions that when executed by the processor(s) cause the one or more processors to: generate data representative of a user interface (UI) for display on a display device, the data representative of the UI comprising UI elements representing one or more fabric design requirements receive, via the UI on the display device, an indication of a user input selecting one or more of the UI elements representing the one or more fabric design requirements; generate a model for a data center fabric based on the one or more fabric design requirements and a catalog of network devices; and generate UI elements representing fabric design specifications of the model for the data center fabric.

## Description

This application claims the benefit of US Patent Application No. 18/478,521, filed 29 September 2023, and claims of the benefit of IN Provisional Patent Application No. 202241067869, filed 25 November 2022, the entire content of each application is incorporated herein by reference.

### TECHNICAL FIELD

The disclosure relates generally to computer networks and, more specifically, to data center fabric design using a user interface.

### BACKGROUND

A data center is a collection of interconnected computer servers and associated components, housed in one or more facilities. In a typical data center, a large collection of interconnected servers provides computing and/or storage capacity for execution of various applications. For example, a data center may comprise a facility that hosts applications and services for subscribers, i.e., customers of the data center. The data center may, for example, host all of the infrastructure equipment, such as networking and storage systems, redundant power supplies, and environmental controls. In most data centers, clusters of storage systems and application servers are interconnected via a high-speed switch fabric provided by one or more tiers of physical network switches and routers. More sophisticated data centers provide infrastructure spread throughout the world with subscriber support equipment in various physical hosting facilities. Data centers are often made up of a large number of devices, including both servers and devices that form a data center fabric. The data center fabric may be represented as an underlay network having leaf and spine network devices. In some examples, the data center fabric is an Internet Protocol (IP) fabric.

### SUMMARY

Particular aspects are set out in the appended independent claims. Various optional embodiments are set out in the dependent claims. In general, this disclosure describes techniques by which a fabric designer system is configured to provide a user interface to enable a user to design a data center fabric. For example, the fabric designer system may generate data representative of a user interface (UI) for display on a display device that includes UI elements that enable the user to specify fabric design requirements. The fabric designer system may obtain, via the user interface, fabric design requirements from the user and obtain catalog information that specifies information for a catalog of physical and/or virtual network devices offered by a provider, and based on the above information, generates a data center fabric model and fabric design specifications (e.g., Bill of Materials (BOM), fabric architecture diagram, etc.) of the data center fabric model for the user.

The techniques of the disclosure may provide one or more technical advantages and practical applications. For example, by providing a user interface by which a user may design a data center fabric, the user may simply design the data center fabric through user inputs to the user interface to specify fabric design requirements to generate and modify data center fabric design specifications of a model for a data center fabric. In this way, the design of a data center fabric no longer necessitates multiple rounds of communication between the customer and subject matter experts (SMEs) to understand the customer's data center fabric requirements, identify network devices that meet the customer's requirements, and the generation and modification of data center fabric design specifications of a model for the data center fabric. Moreover, the fabric design system eliminates the need to use a disaggregated set of tools (e.g., catalog of network devices, design materials specifying data center fabric design specifications, BOMs, etc.) that are often used to exchange information in the process to design a model for the data center fabric, which simplifies the design process.

In one example, the disclosure describes a fabric designer system comprising: one or more processors; and a memory comprising instructions that when executed by the one or more processors cause the one or more processors to: generate data representative of a user interface (UI) for display on a display device, the data representative of the UI comprising UI elements representing one or more fabric design requirements; receive, via the UI on the display device, an indication of a user input selecting one or more of the UI elements representing the one or more fabric design requirements; generate a model for a data center fabric based on the one or more fabric design requirements and a catalog of network devices; and generate UI elements representing fabric design specifications of the model for the data center fabric.

In another example, the disclosure describes a method comprising: generating, by a computing device, data representative of a user interface (UI) for display on a display device, the data representative of the UI comprising UI elements representing one or more fabric design requirements; receiving, by the computing device and via the UI on the display device, an indication of a user input selecting one or more of the UI elements representing the one or more fabric design requirements; generating, by the computing device, a model for a data center fabric based on the one or more fabric design requirements and a catalog of network devices; and generating, by the fabric designer system, UI elements representing fabric design specifications of the model for the data center fabric.

In another example, the disclosure describes computer-readable media comprising instructions that, when executed by processing circuitry, cause the processing circuitry to generate data representative of a user interface (UI) for display on a display device, the data representative of the UI comprising UI elements representing one or more fabric design requirements; receive, via the UI on the display device, an indication of a user input selecting one or more of the UI elements representing the one or more fabric design requirements; generate a model for a data center fabric based on the one or more fabric design requirements and a catalog of network devices; and generate UI elements representing fabric design specifications of the model for the data center fabric.

The details of one or more examples of the techniques of this disclosure are set forth in the accompanying drawings and the description below. Other features, objects, and advantages of the techniques will be apparent from the description and drawings, and from the claims.

### BRIEF DESCRIPTION OF DRAWINGS

FIG. 1 is a block diagram of an example network system including a fabric designer system configured to provide a user interface to enable a user to design a data center fabric, in accordance with one or more techniques of the disclosure.
FIGS. 2A-2Q illustrate examples of one or more user interfaces by which a user may design a data center fabric, in accordance with the techniques described in this disclosure.
FIG. 3 is a block diagram illustrating further details of one example of a computing device that operates in accordance with one or more techniques of the present disclosure.
FIG. 4 is a block diagram illustrating further details of a fabric designer system configured to provide a user interface to enable a user to design a data center fabric, in accordance with one or more techniques of the disclosure.
FIG. 5 is a flowchart of an example process by which a fabric designer system provides a user interface to enable a user to design a data center fabric, in accordance with one or more techniques of the disclosure.

### DETAILED DESCRIPTION

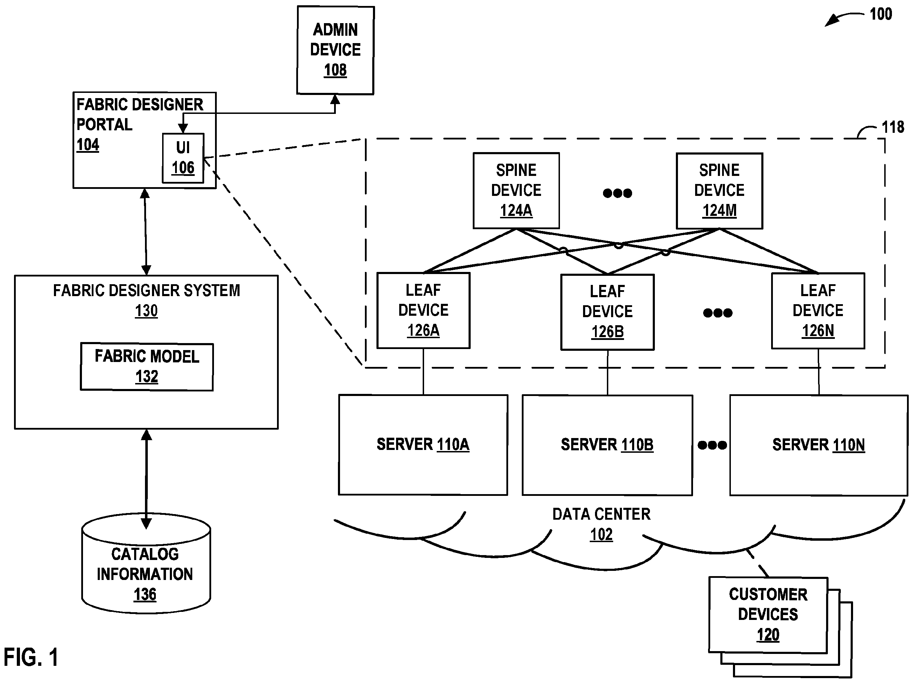

FIG. 1 is a diagram of an example network system 100 including a fabric designer system 130 configured to provide a user interface to enable a user to design a data center fabric. FIG. 1 illustrates an example network system 100 including a data center 102 connected to one or more customer devices, e.g., customer devices 120. Data center 102 may, for example, host infrastructure equipment, such as networking and storage systems, redundant power supplies, and environmental controls. In general, data center 102 provides an operating environment for applications and services for customer devices 120 coupled to the data center, e.g., by a service provider network (not shown). In some examples, a service provider network that couples customer devices 120 to data center 102 may be coupled to one or more networks administered by other providers and may thus form part of a large-scale public network infrastructure, e.g., the Internet.

As illustrated in the example of FIG. 1, data center 102 may be a facility that provides network services for customers through customer devices 120. Customer devices 120 may include the devices of entities (such as enterprises and governments) and of individuals. For example, a network data center may host web services for both enterprises and end users. Other example services may include data storage, virtual private networks, traffic engineering, file service, data mining, scientific- or supercomputing, and so on. In some examples, data center 102 may be individual network servers, network peers, or otherwise. In some examples, data center 102 is an enterprise or internal data center. Data center 102 may represent, for example, one of many geographically distributed network data centers.

Data center 102 may include one or more interconnected servers, e.g., servers 110A-110N (collectively, "servers 110") that each provides execution and storage environments for applications and data associated with customers via customer devices 120 and may be physical servers, virtual machines, containers (including groups of logically-related elements, referred to as "pods"), or combinations thereof. Servers 110 are interconnected via a data center fabric 118, which may comprise a fabric provided by one or more tiers of physical network devices, such as, for example, routers, gateways, switches, hubs, modems, bridges, repeaters, multiplexers, servers, virtual machines or containers running on one or more of the same, and other example network devices.

Data center fabric 118 may be arranged according to various fabric architectures. For example, data center fabric 118 may include a multi-staged (e.g., 3-stage or 5-stage) network or multiplanar network in which each network device (e.g., switch) resides in a defined layer of the network, such as a two-tier layered model (as shown in FIG. 1) or three-tier layered model (not shown). Typically, a three-tier layered model (e.g., IP-CLOS network) comprises a core layer including network devices that provide layer 3 functionality to provide access to servers 110, a distribution layer including network devices that provide an aggregation point for the access layer to connect to the core layer, and an access layer including network devices that provide customer devices 120 with connectivity to the IP fabric. In a two-tier layered model ("collapsed IP fabric" or "collapsed core network"), the core layer and distribution layer are "collapsed" into a single layer in which a network device may implement core layer functions and distribution layer functions. In this example, data center fabric 118 may be represented as an underlay network having spine network devices 124A-124M (collectively, "spine network devices 124") and leaf network devices 126A-126N (collectively "leaf network devices 126"). Data center fabric 118 may also implement an overlay network, such as VXLAN routing and bridging (e.g., Layer 2 and Layer 3 overlay, such as edge-routed bridging (ERB) overlay), VXLAN bridging (e.g., Layer 2 overlay, such as bridged overlay), etc.

Conventional approaches to data center fabric design typically require the use of subject matter experts (SMEs), such as a data center architect, in data center fabric design and is often a time-consuming process. For example, the SME may have knowledge on a catalog of network devices and network topologies in which the network devices may operate in. As such, data center fabric design is often a time-consuming process as it necessitates multiple rounds of communication between a customer and SMEs to understand the customer's data center fabric requirements, identify network devices that meet the customer's requirements, and the generation and modification of data center fabric design specifications of a fabric model for a data center fabric. Moreover, conventional approaches to data center fabric design typically use a disaggregated set of tools that are used to exchange information between the customer and the SMEs, which may further complicate the process to design a fabric model for the data center fabric. For example, the customer and the SMEs may utilize different tools that specify different information for the model for the data center fabric, such as catalogs of network devices (e.g., lists of network devices offered by provider), design materials (e.g., documents, spreadsheets, slide deck presentations) specifying the data center fabric design specifications (e.g., fabric design requirements, fabric architecture diagram, compatible device list), bill of materials, etc.

In accordance with the techniques described in this disclosure, network system 100 includes a fabric designer system 130 configured to provide a user interface to enable a user to design a data center fabric, e.g., data center fabric 118. In this example, fabric designer system 130 is configured to provide a fabric designer portal 104 for use by a user via administrator device 108 ("admin device 108") to design data center fabric 118. In some examples, fabric designer portal 104 can present a user interface (UI) 106 that presents UI elements (e.g., screens, input fields, selectable objects, etc.) for designing data center fabric 118.

Admin device 108 can be an end-user computing device that receives UI elements of user interface 106 for presentation, via a display coupled to admin device 108, to a user operating admin device 108. In some examples, admin device 108 may be operated by a tenant (e.g., customer) of data center 102 and used to manage the design of data center fabric 118. In some examples, admin device 108 may be operated by an administrator of data center 102 and used to manage the design of data center fabric 118.

Fabric designer portal 104 can be communicatively coupled to admin device 108 and fabric designer system 130. In the example illustrated in FIG. 1, fabric designer portal 104 is executed in a cloud computing environment and may be provided as a Software-as-a-Service (SaaS) by a cloud service provider. However, fabric designer portal 104 may be executed in other environments. For example, fabric designer portal 104 may be a component of fabric designer system 130. Further, fabric designer portal 104 may be a component of a server or other computing device in data center 102.

Fabric designer system 130 obtains catalog information 136 that specifies information for a catalog of physical network devices offered by a network device provider and obtains customer requirements (otherwise referred to herein as "fabric design requirements") from a user of admin device 108, and based on the above information, generates fabric design specifications of a fabric model for a data center fabric for the customer, e.g., fabric model 132 for data center fabric 118.

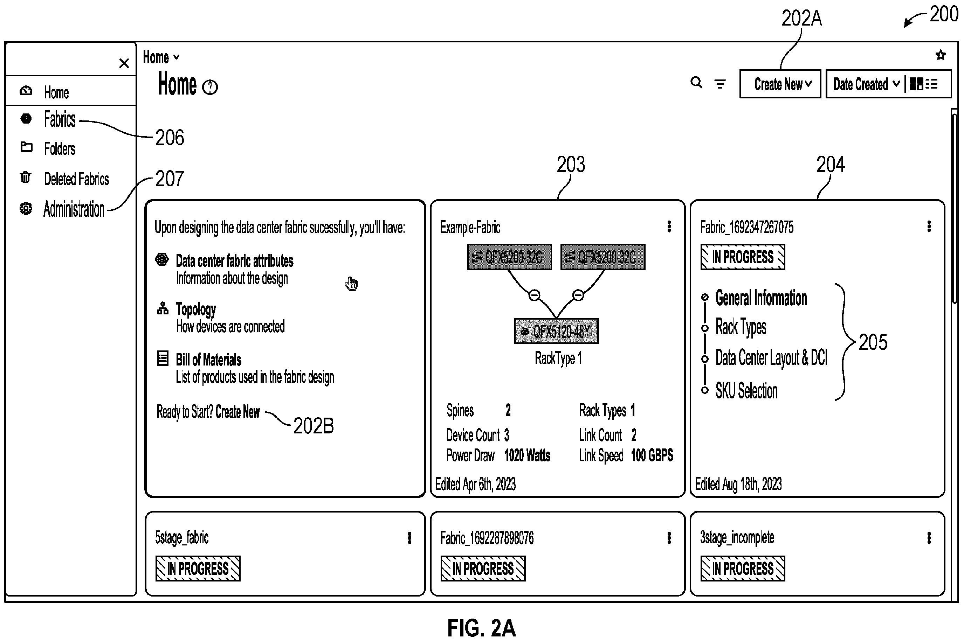

For example, as further described in FIGS. 2A-2Q below, fabric designer system 130 may generate data representative of one or more user interfaces, e.g., user interface 106, for display on a display device that includes UI elements that enable the user to specify the fabric design requirements (otherwise referred to herein as "data center fabric attributes"), such as overlay network requirements (e.g., VXLAN routing and bridging with Layer 2 and Layer 3 overlay, VXLAN bridging with Layer 2 overlay, or IP fabric), connection requirements (e.g., fiber type), power requirements, rack types, pod types, port types, layout, and/or external connectivity details of data center fabric 118. In some examples, fabric design requirements may further include other requirements, such as cost requirements, service level agreement (SLA) requirements, interoperability to one or more other tools, etc.

Fabric designer system 130 may obtain, via user interface 106, an indication of a user input from a user of admin device 108 selecting UI elements representing selected fabric design requirements. Fabric designer system 130 may also obtain catalog information 136 specifying information on physical devices offered by a network device provider, such as cost information, design specifications, and other product details on physical and/or virtual network devices (e.g., routers, gateways, switches, hubs, modems, bridges, repeaters, multiplexers, servers, virtual machines, or containers) and connectors. Catalog information 136 may represent a database, list, or other storage repository including information of a catalog of physical and/or virtual network devices and connectors offered by the provider.

Based on the fabric design requirements and catalog information 136, fabric designer system 130 may generate fabric design specifications of fabric model 132 for a data center fabric, e.g., data center fabric 118. Fabric design specifications of fabric model 132 may include, for example, a fabric architecture diagram specifying one or more selected physical and/or virtual network devices determined to meet the fabric design requirements, the architecture (e.g., topology) in which the one or more selected physical and/or virtual network devices are connected, and the selected connections used to connect the selected physical and/or virtual network devices (e.g., fiber optics connections, virtual connections, etc.). In some examples, fabric designer system 130 may generate fabric model 132 for a data center fabric including a plurality of network devices and a plurality of connections that support the data center fabric from which the user may select the desired network devices and/or connections for the data center fabric. Fabric designer system 130 may also generate fabric model 132 that includes a Bill of Materials (BOM) that specifies information about each of the selected physical and/or virtual network devices and selected connections, such as design specifications (e.g., hardware/software, ports, power supplies, etc.) and a cost to realize the data center fabric design, including the cost of each of the selected network devices and selected connections.

Fabric designer system 130 may generate UI elements representing fabric model 132 (e.g., the fabric architecture design diagram and/or BOM) and output the UI elements for display on user interface 106. In some examples, fabric designer system 130 may receive, via user interface 106, an indication of a user input from the user of admin device 108 selecting UI elements of the fabric architecture design diagram of fabric model 132 to obtain additional details of the selected physical and/or virtual network devices determined to meet the fabric design requirements, the architecture in which the one or more selected physical and/or virtual network devices are interconnected (e.g., fabric attributes, rack type attributes, pod type attributes)), and the selected connections used to connect the selected physical and/or virtual network devices (e.g., connection details). In some examples, fabric designer system 130 may generate fabric design materials (e.g., portable document format (pdf), spreadsheet of BOM, or other file type) of fabric model 132 that specify the data center fabric design specifications and costs, and send the fabric design materials to the user of admin device 108.

FIGS. 2A-2Q illustrate examples of one or more user interfaces by which a user may design a data center fabric, in accordance with the techniques described in this disclosure. The user interface examples described in FIGS. 2A-2Q are described with respect to user interface(s) and UI elements generated by fabric designer system 130 of FIG. 1.

In the example of FIG. 2A, fabric designer system 130 may generate data representative of user interface 200 including UI elements representing selectable options to enable a user to create or edit a fabric model for a data center fabric. For example, user interface 200 may include UI elements representing a selectable option to enable the user to create a new fabric model for a data center fabric (UI elements 202A or 202B), a selectable option to enable the user to create a new fabric model for a data center fabric based on an example fabric model (UI element 203), and/or a selectable option to enable the user to access and/or edit a previously generated data center fabric design specifications (UI element 204). In some examples, user interface 200 may include UI elements representing the current phase in the configuration of a particular fabric model that has not been completed (UI element 205), one or more groupings of one or more fabric models based on type of fabric (e.g., 3-stage, 5-stage, multiplanar) (UI element 206). In some examples, user interface 200 may include UI elements representing selectable options to specify administrative settings for particular users or classes of users of fabric designer system 130 (UI element 207).

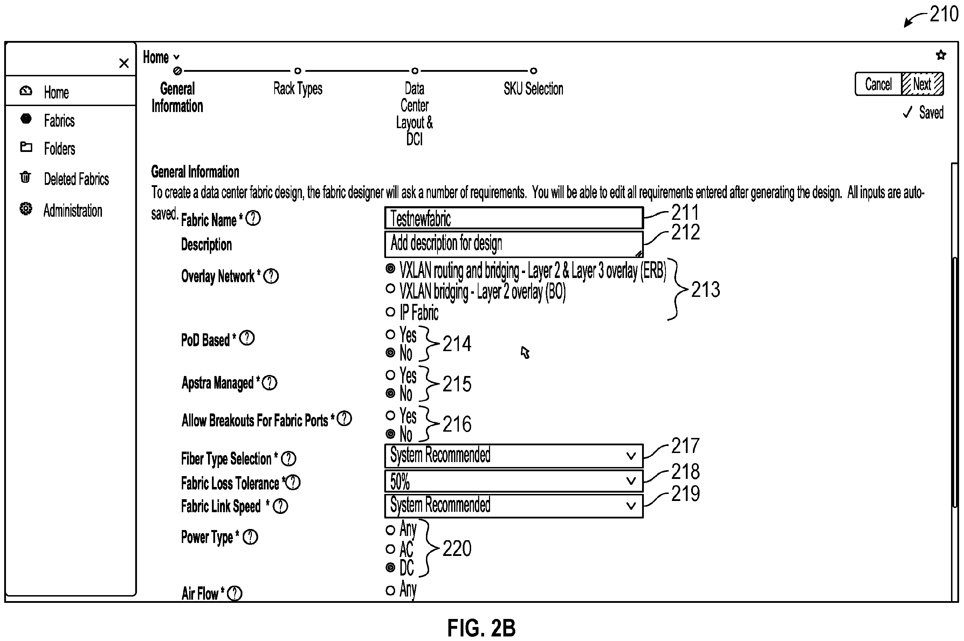

In the example of FIG. 2B, fabric designer system 130 may generate data representative of user interface 210 including UI elements representing selectable options to enable the user to specify fabric design requirements. For example, user interface 210 may include UI elements representing an input field to enable the user to specify a fabric name (UI element 211), an input field to enable the user to specify a description of the fabric (UI element 212), selectable options to enable the user to select an overlay network for the fabric (e.g., VXLAN routing and bridging, VXLAN bridging, or IP fabric) (UI elements 213), selectable options to enable the user to specify whether the data center fabric is pod based or rack based (UI elements 214), selectable options to enable the user to specify whether the data center fabric supports other tools (UI elements 215), a selectable option to enable the user to specify whether to include a license for the other tools and a list with selectable options for the license duration (not shown), a selectable option to enable the user to specify whether to allow breakouts for fabric ports (UI element 216), a list with selectable options to enable the user to specify the fiber type (e.g., single-mode duplex, single-mode parallel, multi-mode duplex, multi-mode parallel, system recommended) (UI element 217), a list with selectable options to enable the user to specify the fabric loss tolerance (UI element 218), a list with selectable options to enable the user to specify the fabric link speed (e.g., specifying a particular fabric link speed or system recommended) (UI element 219), and selectable options to enable the user to specify the power type for the data center fabric (UI elements 220). Other selection options may include selectable options to enable the user to specify an air flow (e.g., any, front to back, back to front), selectable options to enable the user to specify a type of software license (e.g., subscription license, perpetual license) and duration of the license, and selectable options to enable the user to specify the type of hardware support to be provided by the network device provider (e.g., immediate support, future support).

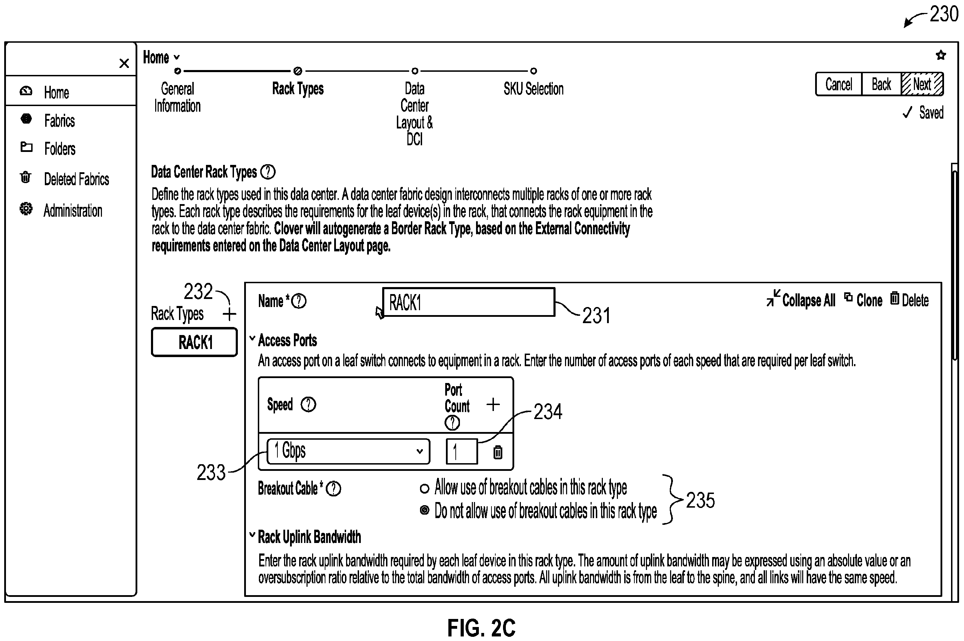

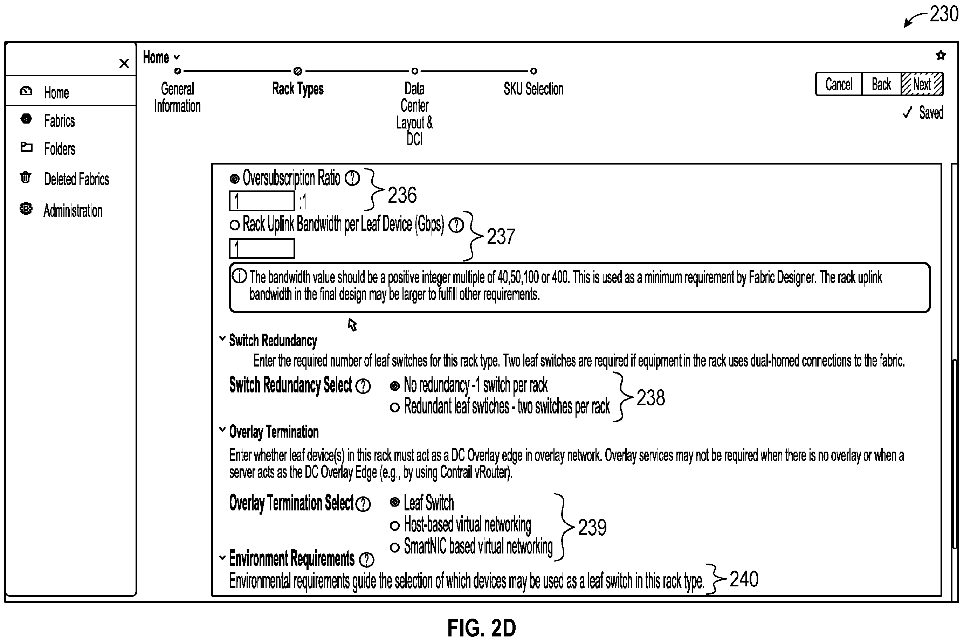

In the example of FIG. 2C, fabric designer system 130 may generate data representative of user interface 230 including UI elements representing selectable options to enable the user to specify rack type requirements for the data center fabric. For example, user interface 230 may include UI elements representing an input field to enable the user to specify a rack name (UI element 231), a selectable option to enable the user to specify a rack type (e.g., storage, application, compute) (UI element 232), a list with selectable options to enable the user to specify the port speed (UI element 233), an input field to enable the user to specify a port count (UI element 234) of leaf devices, selectable options to enable the user to specify whether to use breakout cables (UI elements 235), and other UI elements that enable the user to specify other rack type requirements for the data center fabric, as further illustrated in FIG. 2D.

FIG. 2D illustrates a continued example of user interface 230 including UI elements representing selectable options to enable the user to specify additional rack type requirements for the data center fabric. For example, user interface 230 may include UI elements representing an input field to enable the user to specify an oversubscription ratio (UI element 236), an input field to enable the user to specify a fabric bandwidth per leaf device (UI element 237, selectable options to enable the user to specify a switch redundancy (e.g., no redundancy - one switch per rack, redundant leaf switches - two switches per rack) (UI elements 238), selectable options to enable the user to specify overlay termination (e.g., leaf switch, host-based virtual networking, smartNIC based virtual networking) (UI elements 239), and selectable options to enable the user to specify environmental requirements, such as a list with selectable options to enable the user to specify the leaf device position in the rack, selectable options to enable the user to specify the power type (e.g., any, AC, DC), and selectable options to enable the user to specify whether there is a limit to the power per leaf device (UI element 240).

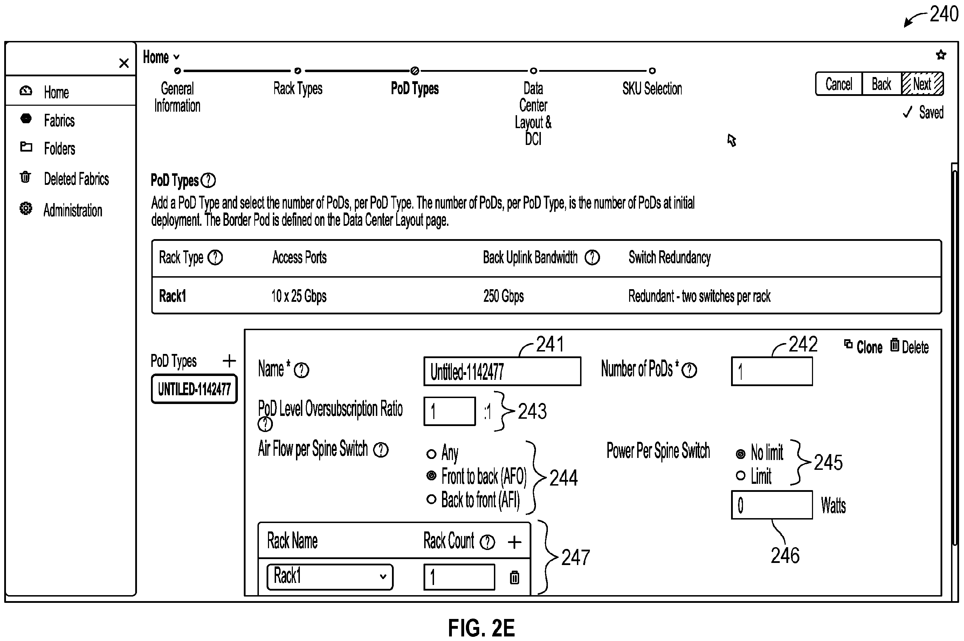

In the example of FIG. 2E, fabric designer system 130 may generate data representative of user interface 240 including UI elements representing selectable options to enable the user to specify pod type requirements for the data center fabric. For example, assume that a user specifies that the data center fabric is pod based (UI elements 214 of user interface 210) for a 5-stage fabric. In this example, fabric designer system 130 may generate data representative of user interface 240 including UI elements representing selectable options to enable the user to specify pod type requirements for the data center fabric, such as an input field to enable the user to specify a name of a pod (UI element 241), an input field to enable the user to specify the number of pods (UI element 242), an input field to enable the user to specify a pod level oversubscription ratio (UI element 243), selectable options to enable the user to specify the air flow per spine device (e.g., any, front to back, back to front) (UI elements 244), selectable options to enable the user to specify whether there is a limit to the power per spine device (UI elements 245) and an input field to enable the user to specify the power to limit (UI element 246), an input field to enable the user to specify a rack count (UI element 247) for a particular rack.

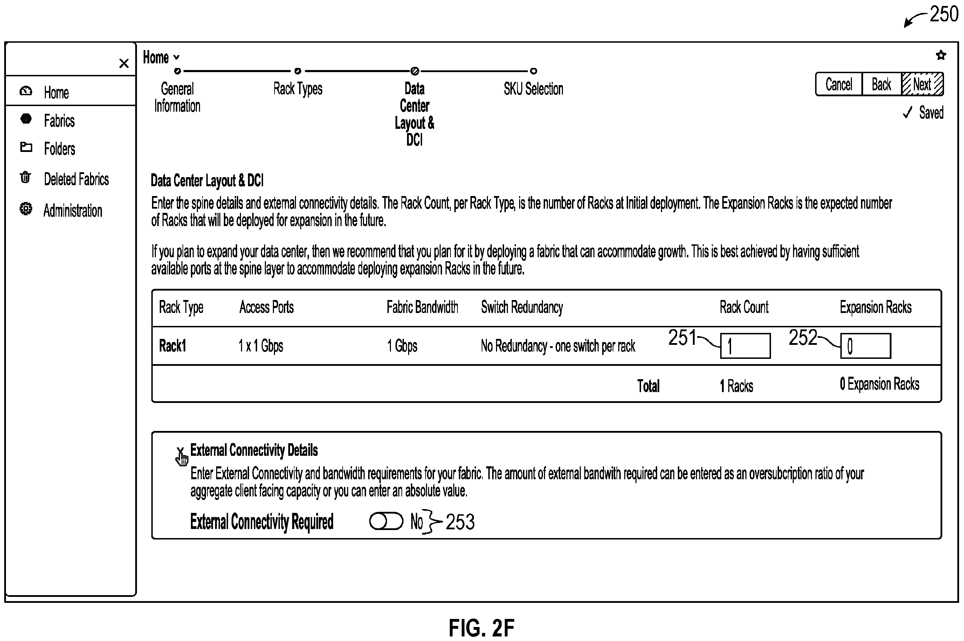

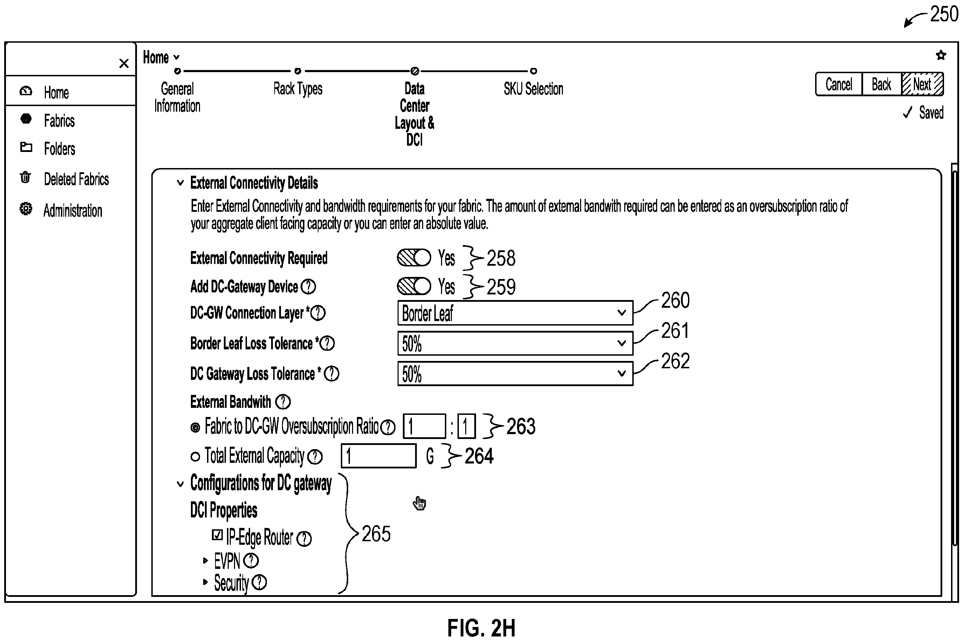

In the example of FIG. 2F, fabric designer system 130 may generate data representative of user interface 250 including UI elements representing selectable options to enable the user to specify a data center layout for the data center fabric without pods (e.g., for a 3-stage fabric). For example, user interface 250 may include UI elements representing selectable options to enable the user to specify spine details, such as an input field to enable the user to specify a rack count at initial deployment (UI element 251) and an input field to enable the user to specify an expected number of racks that may be deployed for expansion in the future (UI elements 252). User interface 250 may include other UI elements that enable the user to specify external connectivity for the data center fabric, as further illustrated in FIG. 2H.

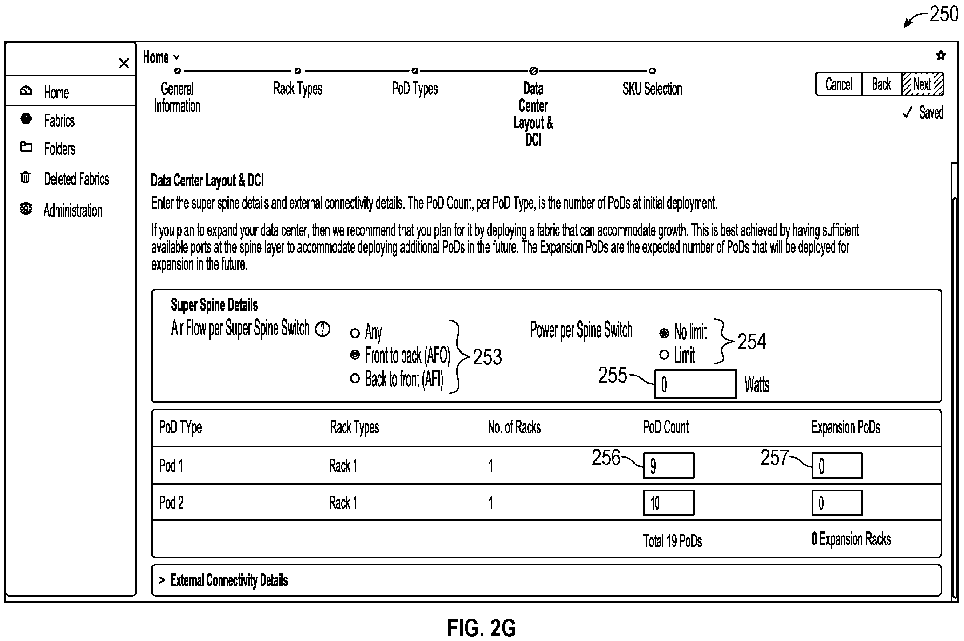

FIG. 2G illustrates another example of user interface 250 including UI elements representing selectable options to enable the user to specify a data center layout for the data center fabric including one or more pods (e.g., for a 5-stage fabric). For example, user interface 250 may include UI elements representing selectable options to enable the user to specify super spine details, such as a selectable option to enable the user to specify an air flow per spine device (UI elements 253) and selectable options to enable the user to specify whether there is a limit to the power per spine device (UI elements 254) and an input field to enable the user to specify the power to limit (UI element 255). User interface 250 may also include UI elements representing an input field to enable the user to specify a pod count at initial deployment of the data center fabric (UI element 256), and an input field to enable the user to specify a number of pods that may be deployed for expansion in the future (UI element 257).

FIG. 2H illustrates a continued example of user interface 250 including UI elements representing selectable options to enable the user to specify external connectivity requirements for the data center fabric. For example, user interface 250 may include UI elements representing selectable options to enable the user to specify external connectivity and bandwidth details, such as a selectable option to enable the user to select whether the fabric is to require external connectivity (UI element 258), a selectable option to enable the user to select whether to add a data center gateway device (UI element 259), a list with selectable options to enable the user to specify the gateway connection layer (e.g., border leaf) (UI element 260), a list with selectable options to enable the user to specify the border leaf loss tolerance (UI element 261), a list with selectable options to enable the user to specify the data center gateway loss tolerance (UI element 262), an input field to enable the user to specify a fabric to data center gateway oversubscription ratio (UI element 263), an input field to enable the user to specify a total external capacity (UI element 264), and other UI elements to enable the user to specify other configurations for the data center gateway, such as data center interconnect properties (e.g., EVPN, security (e.g., PIM support)) (UI elements 265), etc.

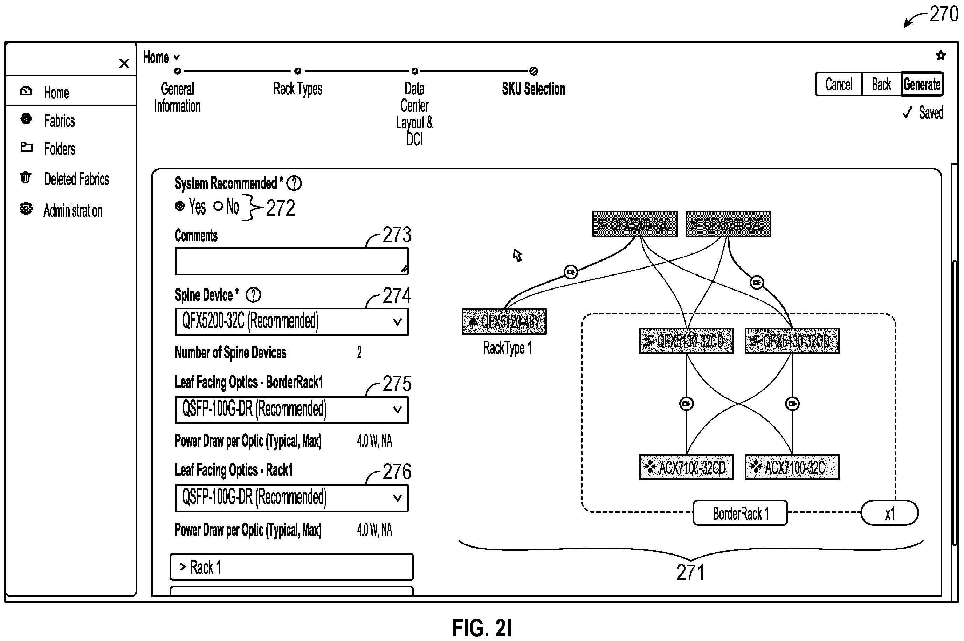

In the example of FIG. 2I, fabric designer system 130 may generate data representative of user interface 270 representing a fabric model of a data center fabric generated based on the data center fabric requirements provided by the user. User interface 270 includes UI elements representing network devices and connections in a data center fabric topology (UI elements 271) selected by fabric designer system 130 based on the data center fabric requirements. User interface 270 may also include UI elements representing selectable options to enable the user to provide modifications to the data center fabric topology selected by fabric designer system 130, such as a selectable option to select whether to keep or modify the recommended selections of network devices and/or connections (referred to herein as SKU selections) of the data center fabric topology (UI element 272), a list with selectable options to enable the user to select another network device for the spine device (UI element 273), a list with selectable options to enable the user to select another network device for the leaf device of a border rack (if the external connectivity requirement was selected) (UI element 274) and/or of a non-border rack (UI element 275), a list with selectable options to enable the user to select another connection type (e.g., cable) (not shown), or other UI elements to enable user input to modify recommendations by fabric designer system 130.

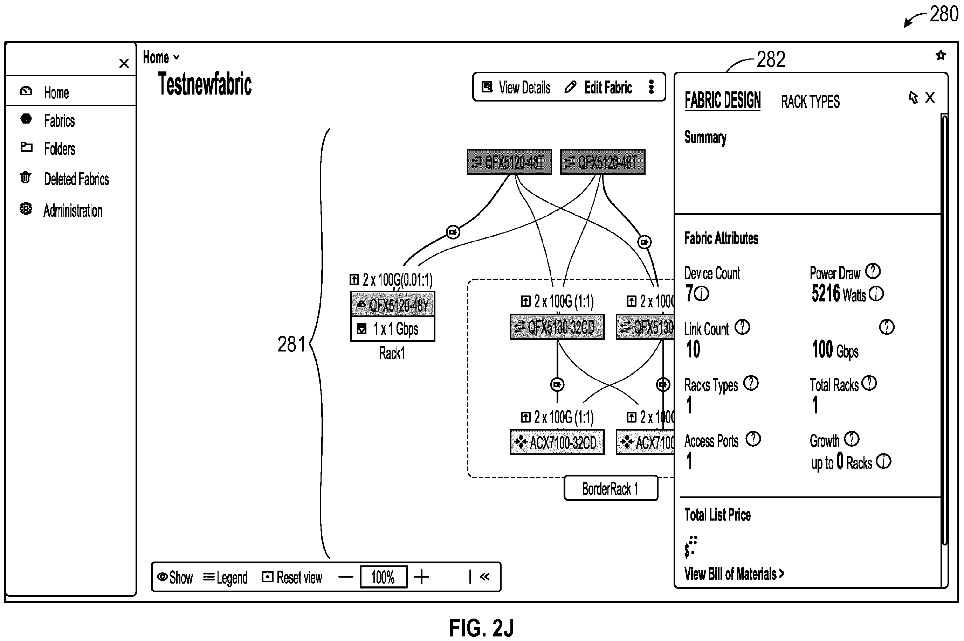

In the example of FIG. 2J, fabric designer system 130 may generate data representative of user interface 280 representing a fabric model of a data center fabric generated based on the data center fabric requirements provided by the user (UI elements 281). User interface 280 includes UI elements representing network devices and connections in a data center fabric topology selected based on the data center fabric requirements (and/or selections of network devices and/or connections with UI elements of user interface 270 of FIG. 2I)). User interface 280 may include a UI element representing a selectable option to enable the user to view a summary of the fabric details (UI element 282). For example, in response to a user input indicating a selection of UI element 282 indicative of a user's selection to view the summary of the data center fabric topology, fabric designer system 130 may generate a pop-up display overlaid (or as a separate display) on user interface 280 with additional information associated with the data center fabric topology, such as fabric attributes including a device count, link count, number of rack types, number of access ports, an amount of power draw, an interface speed, the total number of racks, growth factor, and/or total list price.

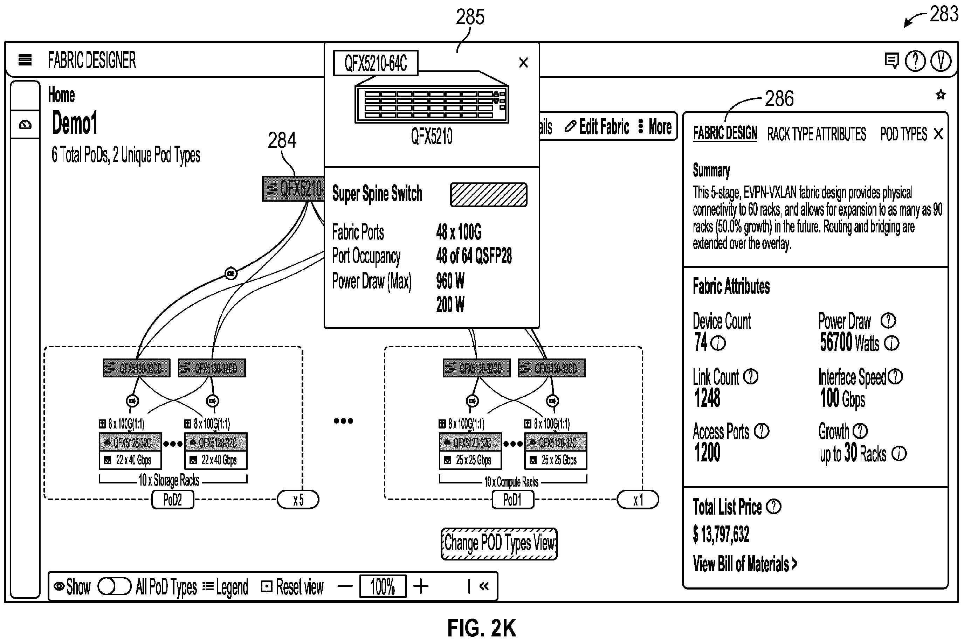

In some examples, fabric designer system 130 may generate data representative of user interface 283 that includes UI elements representing selectable options to enable the user to select (or hover) on a UI element representing a particular network device of the data center fabric topology to obtain additional details of the particular network device, as illustrated in FIG. 2K. For example, in response to a user input indicating a selection of a UI element representing a particular network device of the data center fabric topology (e.g., selection or hovering over UI element 284), fabric designer system 130 may generate a pop-up display (UI element 285) overlaid (or as a separate display) on user interface 283 with additional information associated with the selected network device. User interface 283 may also include interface elements representing selectable options to enable the user to select which additional details of the data center fabric to view, such as fabric design attributes, rack type attributes, and pod type attributes (UI element 286).

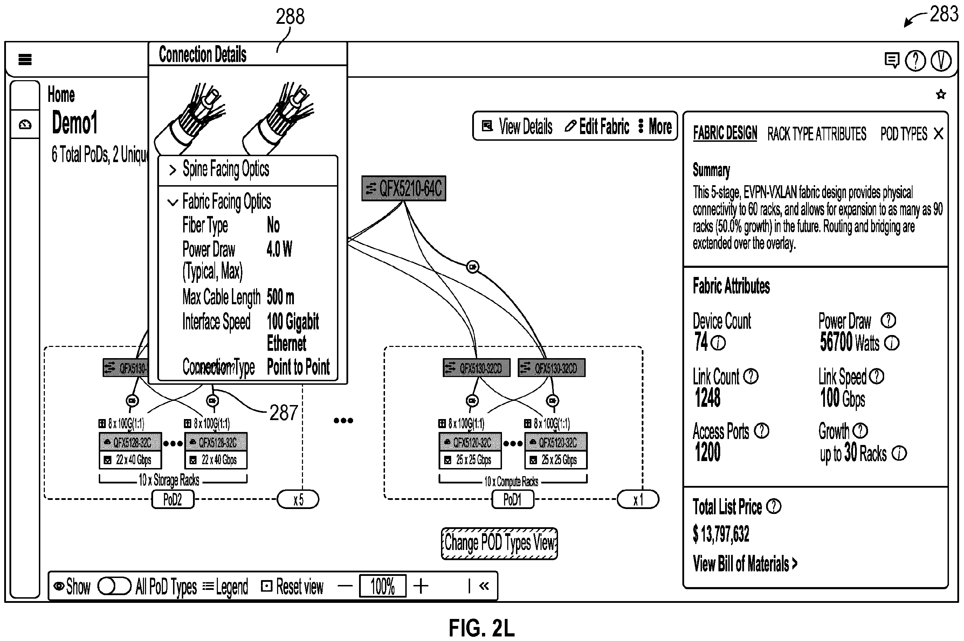

In some examples, fabric designer system 130 may generate data representative of user interface 283 that includes UI elements representing selectable options to enable the user to select (or hover) on a UI element representing a particular connection of the data center fabric topology to obtain additional details of the particular connection, as illustrated in FIG. 2L. For example, in response to a user input indicating a selection of a UI element representing a particular connection (e.g., cable) of the data center fabric topology (e.g., selection or hovering over UI element 287), fabric designer system 130 may generate a pop-up display (UI element 288) overlaid (or as a separate display) on user interface 283 with additional information associated with the selected connection, such as the connector type (e.g., fiber), power draw, length of cable, interface speed, connection type, etc.).

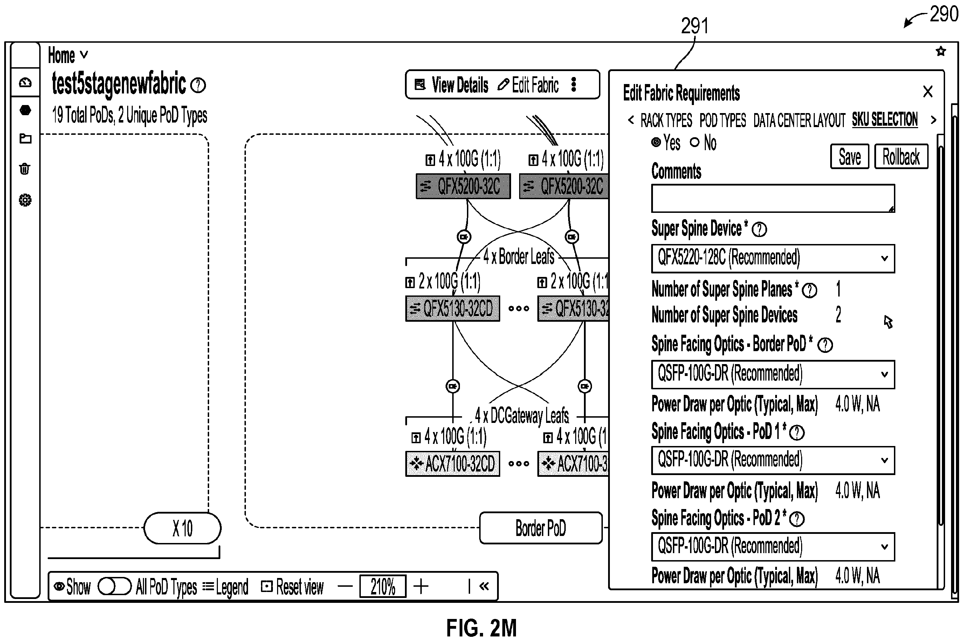

In the example of FIG. 2M, fabric designer system 130 may generate data representative of user interface 290 representing another example of the fabric model of the data center fabric (e.g., a 5-stage fabric including one or more pods). User interface 290 includes UI elements representing pods of a data center fabric topology (e.g., pod view). User interface 290 may include UI elements representing selectable options to enable the user to select (or hover) on a UI element representing a particular pod of the data center fabric topology to obtain additional details of the particular pod. For example, user interface 290 may include UI elements representing a particular pod and in response to a user input (e.g., selection or hovering over the UI element representing the pod), fabric designer system 130 may generate a pop-up display (not shown) overlaid (or as a separate display) on user interface 290 with additional information associated with the selected pod.

In some examples, user interface 290 may include a UI element representing a selectable option to enable the user to modify the fabric requirements (UI element 291). For example, in response to a user input indicating a selection of UI element 291 indicative of a user's selection to modify the fabric requirements of the data center fabric topology, fabric designer system 130 may generate a pop-up display overlaid (or as a separate display) on user interface 291 with UI elements representing one or more selectable options to modify the fabric requirements, such as the fabric requirements for rack types, pod types, data center layout, and/or SKU selections.

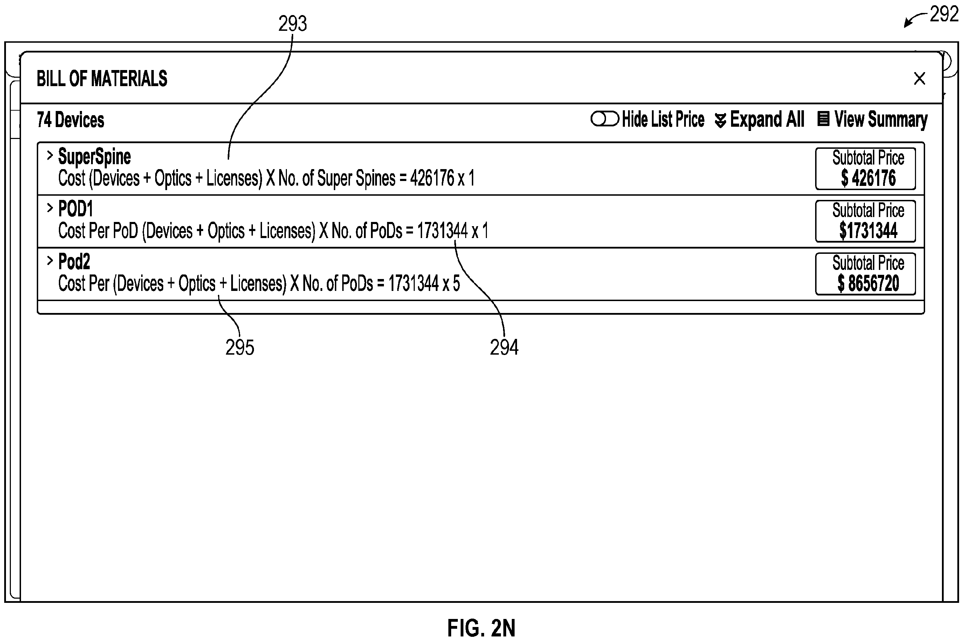

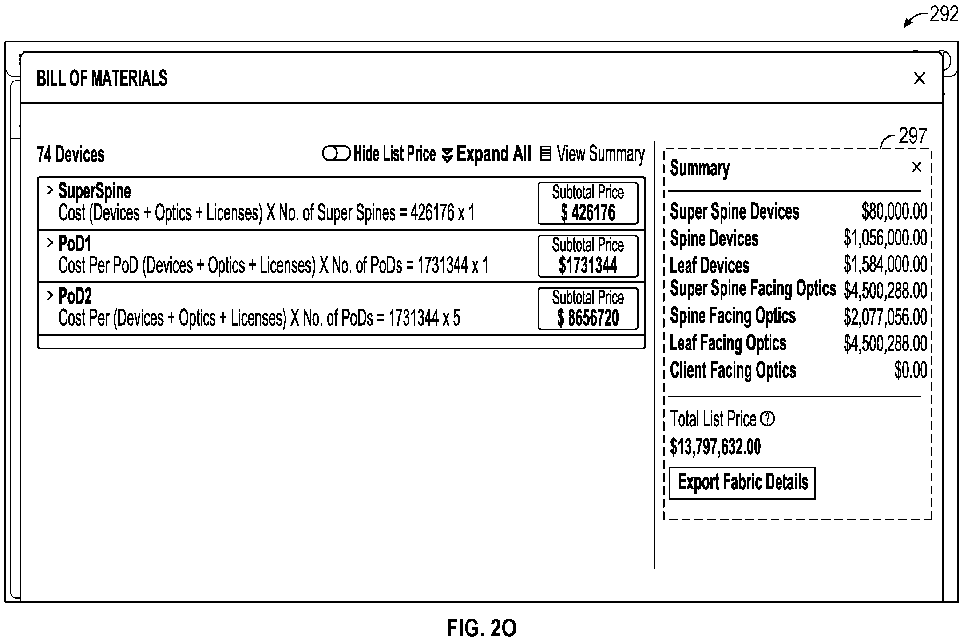

In the example of FIG. 2N, fabric designer system 130 may generate data representative of user interface 292 including UI elements representing a bill of materials of the data center fabric. User interface 292 may include UI elements representing selectable options to enable the user to view additional cost details. For example, user interface 292 may include a UI element representing a selectable option to enable the user to view the summary of the cost details, as further illustrated in FIG. 2O. In the example of FIG. 2O, fabric designer system 130 may generate UI elements of a collapsible display on user interface 292 representing the summary of the cost details for each of the devices and/or connections selected by fabric designer system 130 for the data center fabric.

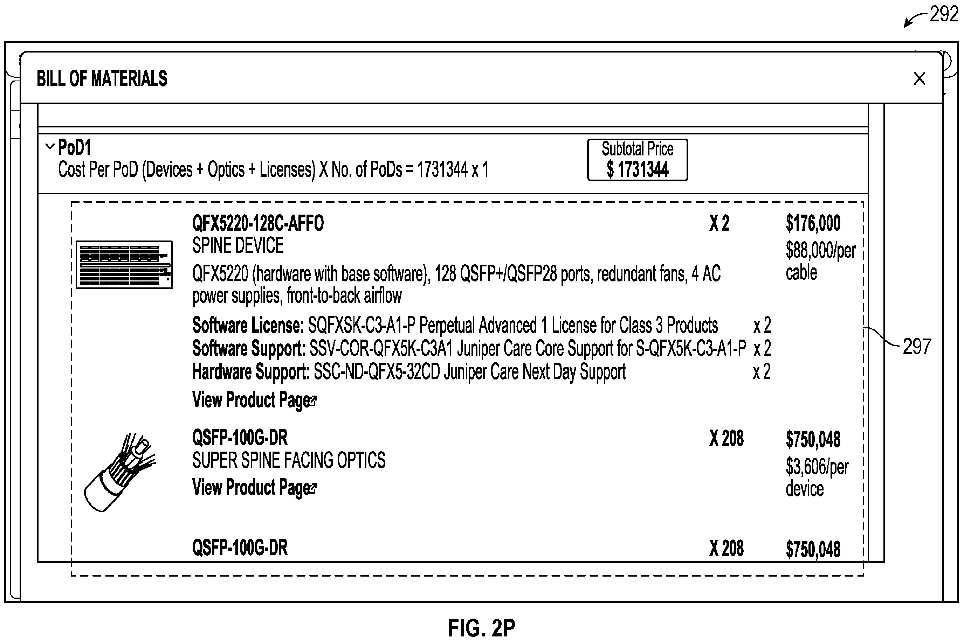

Referring back to FIG. 2N, user interface 292 may include UI elements representing selectable options to enable the user to view additional cost details for particular devices (UI element 293, UI element 294, and UI element 295), as further illustrated in FIG. 2P. In the example of FIG. 2P, fabric designer system 130 may generate UI elements of a collapsible display on user interface 292 representing the cost details for a particular device (e.g., POD1) and connection(s) selected by fabric designer system 130 based on the fabric design requirements (UI element 297).

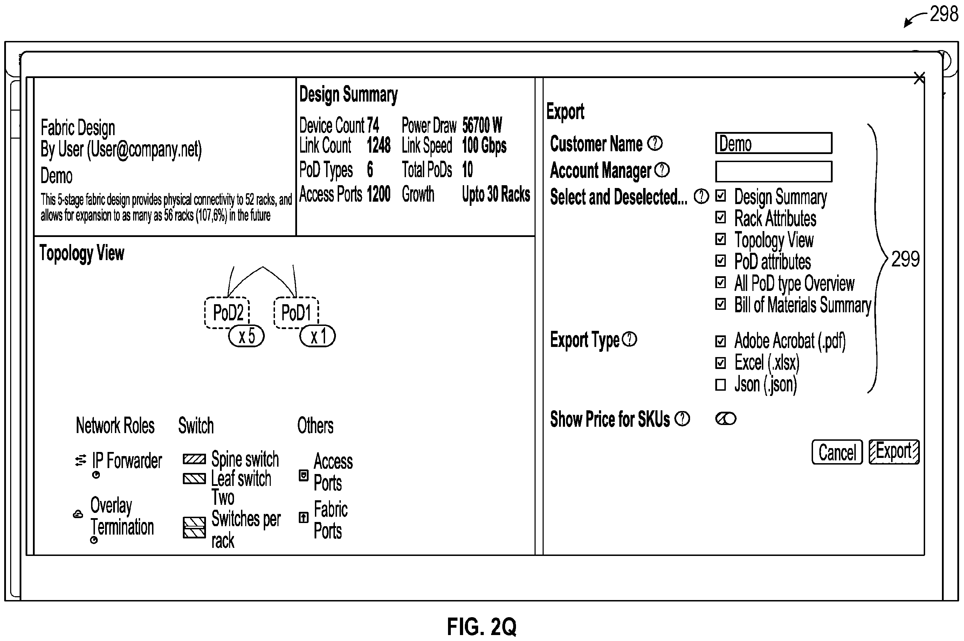

In the example of FIG. 2Q, fabric designer system 130 may generate data representative of user interface 298 including UI elements representing selectable options to enable the user to export fabric design specifications of the fabric model for the data center fabric. For example, user interface 298 may include UI elements representing an input field to enable the user to specify the customer name, an input field to enable the user to specify the account manager, selectable options to enable the user to specify which fabric design specifications to export (e.g., design summary, rack attributes, topology view, pod attributes, all pod type overview, BOM summary), selectable options to enable the user to specify the export type (e.g., PDF, spreadsheet, JSON file), a selectable option to enable the user to specify whether to show the price for the stock keeping units (SKUs) (UI elements 299), and a selectable option to enable the user to export the fabric design specifications.

The UI elements in FIGS. 2A-2Q are merely examples and may include any type of UI element (e.g., input field, selectable options, list with selectable options, etc.). The UI elements in FIGS. 2A-2Q may also include different and/or additional UI elements representing selectable options to enable the user to specify other fabric design requirements, such as cost requirements, SLA requirements, etc.

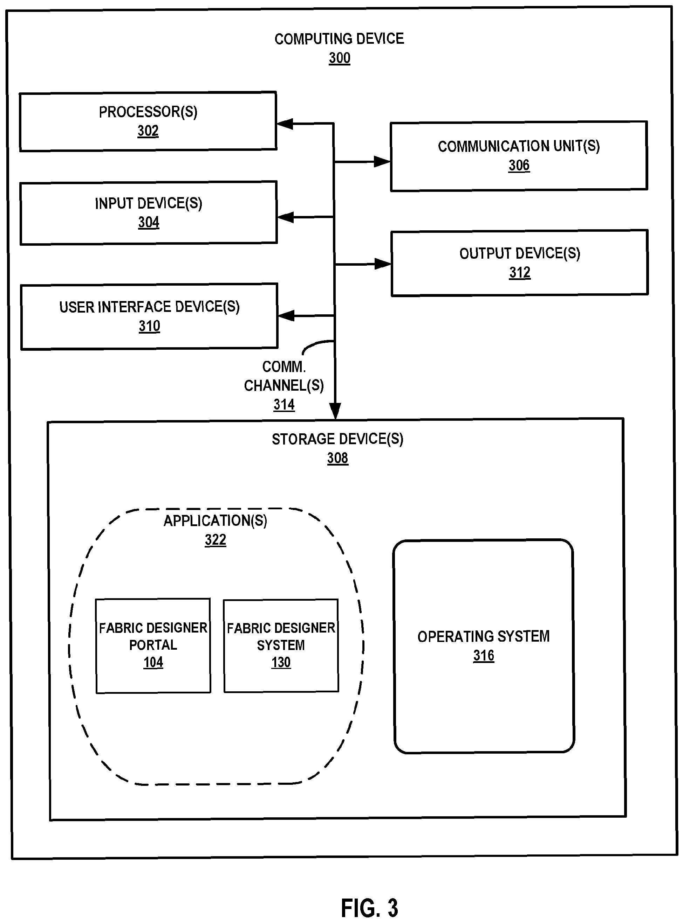

FIG. 3 is a block diagram illustrating further details of one example of a computing device that operates in accordance with one or more techniques of the present disclosure. FIG. 3 may illustrate a particular example of a server or other computing device 300 that includes one or more processor(s) 302 for executing any one or more of fabric designer portal 104, fabric designer system 130, or any other system, application, software, or module described herein. Other examples of computing device 300 may be used in other instances. Although shown in FIG. 3 as a stand-alone computing device 300 for purposes of example, a computing device may be any component or system that includes one or more processors or other suitable computing environment for executing software instructions and, for example, need not necessarily include one or more elements shown in FIG. 3 (e.g., communication units 306; and in some examples components such as storage device(s) 308 may not be co-located or in the same chassis as other components).

As shown in the specific example of FIG. 3, computing device 300 includes one or more processors 302, one or more input devices 304, one or more communication units 306, one or more output devices 312, one or more storage devices 308, and user interface (UI) device 310. Computing device 300, in one example, further includes one or more applications 322 and operating system 316 that are executable by computing device 300. Each of components 302, 304, 306, 308, 310, and 312 are coupled (physically, communicatively, and/or operatively) for inter-component communications. In some examples, communication channels 314 may include a system bus, a network connection, an inter-process communication data structure, a message bus, or any other method for communicating data. As one example, components 302, 304, 306, 308, 310, and 312 may be coupled by one or more communication channels 314.

Processors 302, in one example, are configured to implement functionality and/or process instructions for execution within computing device 300. For example, processors 302 may be processing circuitry capable of processing instructions stored in one or more storage device 308. Examples of processors 302 may include, any one or more of a microprocessor, a controller, a digital signal processor (DSP), an application specific integrated circuit (ASIC), a field-programmable gate array (FPGA), or equivalent discrete or integrated logic circuitry.

One or more storage devices 308 may be configured to store information within computing device 300 during operation. Storage device 308, in some examples, is described as a computer-readable storage medium. In some examples, storage device 308 is a temporary memory, meaning that a primary purpose of storage device 308 is not long-term storage. Storage device 308, in some examples, is described as a volatile memory, meaning that storage device 308 does not maintain stored contents when the computer is turned off. Examples of volatile memories include random access memories (RAM), dynamic random access memories (DRAM), static random access memories (SRAM), and other forms of volatile memories known in the art. In some examples, storage device 308 is used to store program instructions for execution by processors 302. Storage device 308, in one example, is used by software or applications running on computing device 300 to temporarily store information during program execution.

Storage devices 308, in some examples, also include one or more computer-readable storage media. Storage devices 308 may be configured to store larger amounts of information than volatile memory. Storage devices 308 may further be configured for long-term storage of information. In some examples, storage devices 308 include non-volatile storage elements. Examples of such non-volatile storage elements include magnetic hard discs, optical discs, floppy discs, flash memories, or forms of electrically programmable memories (EPROM) or electrically erasable and programmable (EEPROM) memories.

Computing device 300, in some examples, also includes one or more communication units 306. Computing device 300, in one example, utilizes communication units 306 to communicate with external devices via one or more networks, such as one or more wired/wireless/mobile networks. Communication units 306 may include a network interface card, such as an Ethernet card, an optical transceiver, a radio frequency transceiver, or any other type of device that can send and receive information. In some examples, computing device 300 uses communication unit 306 to communicate with an external device.

Computing device 300, in one example, also includes one or more user interface devices 310. User interface devices 310, in some examples, are configured to receive input from a user through tactile, audio, or video feedback. Examples of user interface devices(s) 310 include a presence-sensitive display, a mouse, a keyboard, a voice responsive system, video camera, microphone or any other type of device for detecting a command from a user. In some examples, a presence-sensitive display includes a touchsensitive screen.

One or more output devices 312 may also be included in computing device 300. Output device 312, in some examples, is configured to provide output to a user using tactile, audio, or video stimuli. Output device 312, in one example, includes a presence-sensitive display, a sound card, a video graphics adapter card, or any other type of device for converting a signal into an appropriate form understandable to humans or machines. Additional examples of output device 312 include a speaker, a cathode ray tube (CRT) monitor, a liquid crystal display (LCD), or any other type of device that can generate intelligible output to a user.

Computing device 300 may include operating system 316. Operating system 316, in some examples, controls the operation of components of computing device 300. For example, operating system 316, in one example, facilitates the communication of one or more applications 322 with processors 302, communication unit 306, storage device 308, input device 304, user interface devices 310, and output device 312.

Applications 322 may also include program instructions and/or data that are executable by computing device 300. Example applications 322 executable by computing device 300 may include applications and/or other software to implement capabilities described above. For example, applications 322 can include applications associated with fabric designer portal 104 and fabric designer system 130 of FIG. 1.

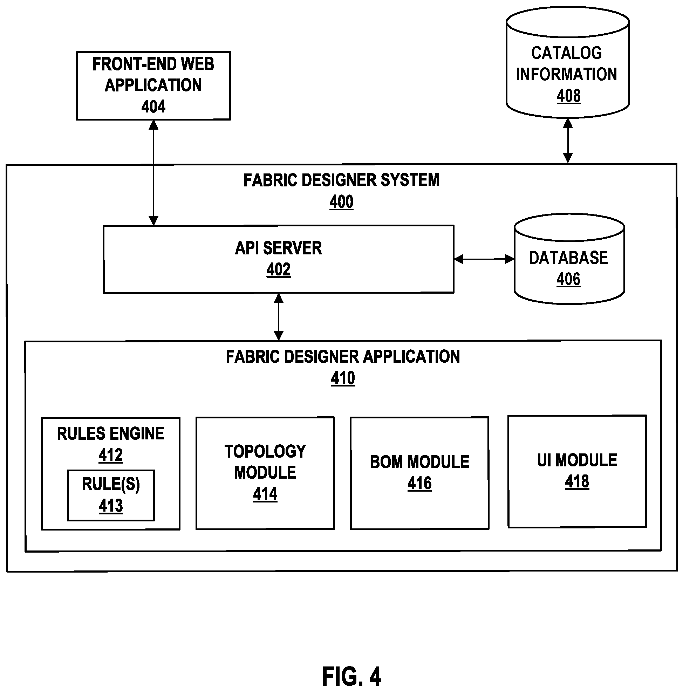

FIG. 4 is a block diagram illustrating further details of a fabric designer system configured to provide a user interface to enable a user to design a data center fabric, in accordance with one or more techniques of the disclosure. In this example, fabric designer system 400 may represent an example implementation of fabric designer system 130 in FIGS. 1 and 3.

In some examples, fabric designer system 400 may generate data representative of a user interface, e.g., front-end web application 404, for display on a display device that includes UI elements that enable the user to specify the fabric design requirements (e.g., rack types, pod types, port types, and layout of a data center fabric) and UI elements that specify the data center fabric design, topology, and BOM generated by fabric designer application 410 (e.g., application associated with fabric designer system 130 of FIGS. 1 and 3). Front-end web application 404 may represent an example implementation of user interface 106 of FIG. 1.

Fabric designer system 400 includes an application programming interface (API) server 402 that runs an API to communicate between front-end web application 404 and fabric designer application 410. For example, fabric designer system 400 may use the API to obtain an indication of a user input from a user selecting the UI elements representing selected fabric design requirements. Fabric designer system 400 may also use the API to send UI elements representing the data center fabric design, topology, and BOM generated by fabric designer application 410 to front-end web application 404. Fabric designer system 400 may store data from front-end web application 404 (e.g., user input) and data from fabric designer application 410 (e.g., data center fabric design, topology, and BOM) in database 406.

Fabric designer system 400 may also obtain catalog information 408 that specifies information for a catalog of physical network devices offered by a network device provider, such as cost information, design specifications, and other product details on physical network devices (e.g., routers, gateways, switches, hubs, modems, bridges, repeaters, multiplexers, servers, virtual machines, or containers) offered by a provider. For example, fabric designer system 400 may include an interface (e.g., API) to obtain catalog information 408 from a data source, e.g., a database, list, or other storage repository including information for a catalog of physical network devices offered by the provider. Fabric designer system 400 may obtain catalog information 408 on a continuous basis, periodic basis, event-driven basis (e.g., update to catalog with new network devices, network devices marked as end-of-life, new prices, new compatibilities, etc.), or other type of basis. In some examples, fabric designer system 400 may store data from catalog information 408 in database 406.

Fabric designer application 410 may transform user inputs received from front-end web application 404 into a fabric model (e.g., model of physical and logical topologies and a bill of materials) for a data center fabric. For example, fabric designer application 410 may include rules engine 412, topology module 414, BOM module 416, and UI module 418.

Rules engine 412 may apply one or more rules 413 by which the data center fabric is to select network devices for the data center fabric design. For instance, the one or more rules 413 may comprise a rule that specifies the design of the data center fabric is based on a radix of the network devices (e.g., number of ports provided to connect to adjacent routers). As one example, rules engine 412 may select leaf network devices for the data center fabric based on maximum port utilization and select spine network devices for the data center fabric based on a growth factor (e.g., maximum port availability). The one or more rules may additionally, or alternatively, comprise other rules that each specify a fabric design requirement provided by the customer (e.g., overlay requirements, rack types, pod types, cost requirements, etc.). In some examples, rules engine 412 may apply a rule to override aspects of the data center fabric design (e.g., if an overriding option is selected by the user), such as overriding the selected network devices, selected connections, and/or fabric design architecture with user-specified changes. In some examples, rules engine 412 may apply a rule to provide multiple options of selected network devices, selected connections, and/or fabric design architectures from which the user may select a preferred option.

Topology module 414 may determine the topology of the fabric. For example, topology module 414 may arrange selected network devices and connections in accordance with a particular fabric architecture (e.g., two-tiered layered model, three-tier layered model, etc.). Topology module 414 may arrange selected network devices and connections based on fabric design requirements and the capabilities of network devices that support the fabric design requirements.

BOM module 416 may generate a bill of materials that specifies information about each of the selected physical network devices and selected connections, such as design specifications (e.g., hardware/software, ports, power supplies, etc.) and a cost to realize the data center fabric design, including the cost of each of the selected network devices and selected connections.

In the example of FIG. 4, fabric designer application 410 may include UI module 418 to generate data representative of a user interface to enable a user to design a data center fabric. Although UI module 418 is illustrated as included in fabric designer application 410, UI module 418 may be a separate module accessible by fabric designer application 410.

Fabric designer application 410 may cause UI module 418 to generate data representative of a user interface to enable a user to design a data center fabric. For example, fabric designer application 410 may cause UI module 418 to generate data representative of a user interface (e.g., user interfaces illustrated in FIGS. 2A-2M) including UI elements that represent selectable options to enable the user to specify fabric design requirements, and UI elements that represent network devices and connections arranged in a data center fabric topology of a fabric model for a data center fabric where the UI elements enable the user to select (or hover) on the UI element representing a particular network device or connection of the fabric model for the data center fabric to obtain additional details of the particular network device or connection and/or a bill of materials for the data center fabric. Fabric designer application 410 may further cause UI module 418 to generate data representative of a user interface including UI elements that represent selectable options to enable the user to export fabric design specifications of a fabric model for a data center fabric.

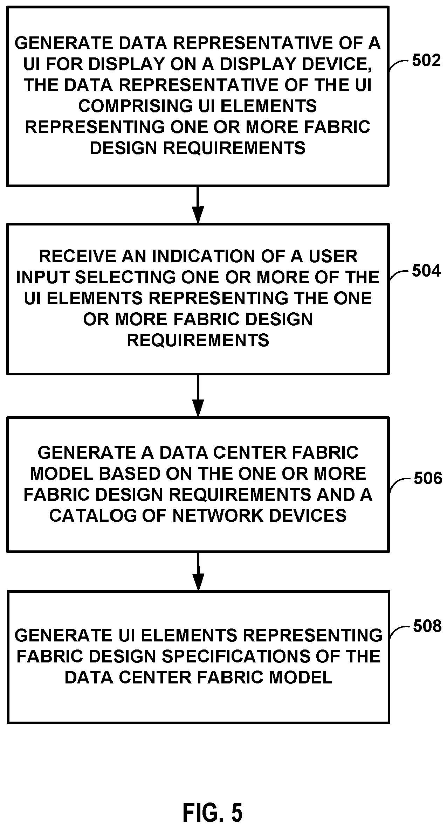

FIG. 5 is a flowchart of an example process by which a fabric designer system provides a user interface to enable a user to design a data center fabric, in accordance with one or more techniques of the disclosure. FIG. 5 is described with respect to fabric designer system 130 of FIG. 1 and/or fabric designer system 400 of FIG. 4.

In this example, fabric designer system 130 may generate data representative of a user interface for display on a display device, the data representative of the user interface comprising user interface elements representing one or more fabric design requirements (502). For example, fabric designer system 130 may generate data representative of a user interface (e.g., user interfaces illustrated in FIGS. 2A-2M) including UI elements that represent, for example, selectable options to enable the user to specify fabric design requirements for a data center fabric, such as overlay network requirements, connection requirements, power requirements, rack types, pod types, port types, and layout of the data center fabric.

Fabric designer system 130 may receive, via the user interface on the display device, an indication of a user input selecting one or more of the UI elements representing the one or more fabric design requirements (504) and generate a data center fabric model for a data center fabric based on the one or more fabric design requirements and a catalog of network devices (506). For example, a user may select one or more of the UI elements, and fabric designer system 130 may obtain the user input (e.g., via API server 402) and fabric designer system 130 may transform the user inputs received from the user interface into a fabric model (e.g., model of physical and logical topologies of a data center fabric and a bill of materials) for a data center fabric, e.g., via rule engine 412, topology module 414, and BOM module 416.

Thus, from one perspective, there have now been described techniques by which a fabric designer system provides a user interface (UI) to enable a user to design a data center fabric. For example, a fabric designer system comprises processor(s) and a memory comprising instructions that when executed by the processor(s) cause the one or more processors to: generate data representative of a user interface (UI) for display on a display device, the data representative of the UI comprising UI elements representing one or more fabric design requirements receive, via the UI on the display device, an indication of a user input selecting one or more of the UI elements representing the one or more fabric design requirements; generate a model for a data center fabric based on the one or more fabric design requirements and a catalog of network devices; and generate UI elements representing fabric design specifications of the model for the data center fabric.

In response to generating the fabric model for the data center fabric, fabric designer system 130 generates UI elements representing fabric design specifications of the fabric model for the data center fabric (508). For example, fabric designer system 130 may generate UI elements representing network devices and connections arranged in a data center fabric topology of a fabric model for a data center fabric. The UI elements representing the network devices and connections enable the user to select (or hover) on a UI element representing a particular network device or connection to obtain additional details of the particular network device or connection. In some examples, fabric designer system 130 may generate UI elements representing a bill of materials for the data center fabric, and selectable options to enable the user to export fabric design specifications of the fabric model for the data center fabric.

The techniques described in this disclosure may be implemented, at least in part, in hardware, software, firmware or any combination thereof. For example, various aspects of the described techniques may be implemented within one or more programmable processors, including one or more microprocessors, digital signal processors (DSPs), application specific integrated circuits (ASICs), field programmable gate arrays (FPGAs), or any other equivalent integrated or discrete logic circuitry, as well as any combinations of such components. The term "processor" or "processing circuitry" may generally refer to any of the foregoing logic circuitry, alone or in combination with other logic circuitry, or any other equivalent circuitry. A control unit comprising hardware may also perform one or more of the techniques of this disclosure.

Such hardware, software, and firmware may be implemented within the same device or within separate devices to support the various operations and functions described in this disclosure. In addition, any of the described units, modules or components may be implemented together or separately as discrete but interoperable logic devices. Depiction of different features as modules or units is intended to highlight different functional aspects and does not necessarily imply that such modules or units must be realized by separate hardware or software components. Rather, functionality associated with one or more modules or units may be performed by separate hardware or software components or integrated within common or separate hardware or software components.

The techniques described in this disclosure may also be embodied or encoded in a computer-readable medium, such as a computer-readable storage medium, containing instructions. Instructions embedded or encoded in a computer-readable medium may cause a programmable processor, or other processor, to perform the method, e.g., when the instructions are executed. Computer-readable media may include non-transitory computer-readable storage media and transient communication media. Computer readable storage media, which is tangible and non-transitory, may include random access memory (RAM), read only memory (ROM), programmable read only memory (PROM), erasable programmable read only memory (EPROM), electronically erasable programmable read only memory (EEPROM), flash memory, a hard disk, a CD-ROM, a floppy disk, a cassette, magnetic media, optical media, or other computer-readable storage media. The term "computer-readable storage media" refers to physical storage media, and not signals, carrier waves, or other transient media. Additionally, or alternatively, a computer-readable medium can include signals, carrier waves, or other transient media.

Further examples of feature combinations taught by the present disclosure are set out in the following numbered clauses:
1. A fabric designer system comprising:
   one or more processors; and
   a memory comprising instructions that when executed by the one or more processors cause the one or more processors to:
      generate data representative of a user interface (UI) for display on a display device, the data representative of the UI comprising UI elements representing one or more fabric design requirements;
      receive, via the UI on the display device, an indication of a user input selecting one or more of the UI elements representing the one or more fabric design requirements;
      generate a model for a data center fabric based on the one or more fabric design requirements and a catalog of network devices; and
      generate UI elements representing fabric design specifications of the model for the data center fabric.
2. The fabric designer system of clause 1, wherein the fabric design specifications of the data center fabric comprise a bill of materials.
3. The fabric designer system of clause 1 or clause 2, wherein the fabric design specifications of the data center fabric comprise a fabric architecture diagram.
4. The fabric designer system of any preceding clause, wherein the instructions further cause the one or more processors to:
   export the fabric design specifications.
5. The fabric designer system of any preceding clause, wherein to receive the indication of the user input selecting one or more of the UI elements representing the one or more fabric design requirements, the instructions cause the one or more processors to:
   receive the indication of the user input via an application programming interface (API).
6. The fabric designer system of any preceding clause, wherein to generate the data center fabric based on the one or more fabric design requirements and the catalog of network devices, the one or more instructions cause the one or more processors to:
   apply one or more rules to select one or more network devices from the catalog of network devices.
7. The fabric designer system of clause 6, wherein the one or more rules comprise a rule to select the one or more network devices based on a radix of the one or more network devices.
8. The fabric designer system of clause 6 or clause 7, wherein the one or more rules comprise a rule to select the one or more network devices based on cost requirements.
9. The fabric designer system of any of clauses 6 to 8, wherein the one or more rules comprise a rule to override one or more network devices or one or more connections selected for the data center fabric.
10. The fabric designer system of any preceding clause, wherein to generate the model for the data center fabric based on the one or more fabric design requirements and the catalog of network devices, the one or more instructions cause the one or more processors to:
   generate the model for the data center fabric including:
   a plurality of network devices that support the data center fabric; and
   a plurality of connections that support the data center fabric.
11. A method comprising:
   generating, by a computing device, data representative of a user interface (UI) for display on a display device, the data representative of the UI comprising UI elements representing one or more fabric design requirements;
   receiving, by the computing device and via the UI on the display device, an indication of a user input selecting one or more of the UI elements representing the one or more fabric design requirements;
   generating, by the computing device, a model for a data center fabric based on the one or more fabric design requirements and a catalog of network devices; and
   generating, by the computing device, UI elements representing fabric design specifications of the model for the data center fabric.
12. The method of clause 11, wherein the fabric design specifications of the data center fabric comprise at least one of a bill of materials or a fabric architecture diagram.
13. The method of clause 11 or clause 12, further comprising:
   exporting, by the computing device, the fabric design specifications.
14. The method of any of clauses 11 to 13, wherein receiving the indication of the user input selecting one or more of the UI elements representing the one or more fabric design requirements comprises:
   receiving, by the computing device, the indication of the user input via an application programming interface (API).
15. The method of any of clauses 11 to 14, wherein generating the data center fabric based on the one or more fabric design requirements and the catalog of network devices comprises:
   applying, by the computing device, one or more rules to select one or more network devices from the catalog of network devices.
16. The method of clause 15, wherein the one or more rules comprise at least one of a rule to select the one or more network devices based on a radix of the one or more network devices.
17. The method of clause 15 or clause 16, wherein the one or more rules comprise a rule to select the one or more network devices based on cost requirements.
18. The system of any of clauses 15 to 17, wherein the one or more rules comprise a rule to override one or more network devices or one or more connections selected for the data center fabric.
19. The method of any of clauses 11 to 18, wherein generating the model for the data center fabric based on the one or more fabric design requirements and the catalog of network devices comprises:
   generating the model for the data center fabric including:
   a plurality of network devices that support the data center fabric; and
   a plurality of connections that support the data center fabric.
20. A computer-readable media comprising instructions that, when executed by processing circuitry, cause the processing circuitry to:
   generate data representative of a user interface (UI) for display on a display device, the data representative of the UI comprising UI elements representing one or more fabric design requirements;
   receive, via the UI on the display device, an indication of a user input selecting one or more of the UI elements representing the one or more fabric design requirements;
   generate a model for a data center fabric based on the one or more fabric design requirements and a catalog of network devices; and
   generate UI elements representing fabric design specifications of the model for the data center fabric.

## Claims

1. A fabric designer system comprising:
one or more processors; and
a memory comprising instructions that when executed by the one or more processors cause the one or more processors to:
generate data representative of a user interface, UI, for display on a display device, the data representative of the UI comprising UI elements representing one or more fabric design requirements;
receive, via the UI on the display device, an indication of a user input selecting one or more of the UI elements representing the one or more fabric design requirements;
generate a model for a data center fabric based on the one or more fabric design requirements and a catalog of network devices; and
generate UI elements representing fabric design specifications of the model for the data center fabric.

2. The fabric designer system of claim 1, wherein the fabric design specifications of the data center fabric comprise a bill of materials.

3. The fabric designer system of any of claims 1-2, wherein the fabric design specifications of the data center fabric comprise a fabric architecture diagram.

4. The fabric designer system of any of claims 1-3, wherein the instructions further cause the one or more processors to:
export the fabric design specifications.

5. The fabric designer system of any of claims 1-4, wherein to receive the indication of the user input selecting one or more of the UI elements representing the one or more fabric design requirements, the instructions cause the one or more processors to:
receive the indication of the user input via an application programming interface, API.

6. The fabric designer system of any of claims 1-5, wherein to generate the data center fabric based on the one or more fabric design requirements and the catalog of network devices, the one or more instructions cause the one or more processors to:
apply one or more rules to select one or more network devices from the catalog of network devices.

7. The fabric designer system of claim 6, wherein the one or more rules comprise a rule to select the one or more network devices based on a radix of the one or more network devices.

8. The fabric designer system of any of claims 6-7, wherein the one or more rules comprise a rule to select the one or more network devices based on cost requirements.

9. The fabric designer system of any of claims 6-8, wherein the one or more rules comprise a rule to override one or more network devices or one or more connections selected for the data center fabric.

10. The fabric designer system of any of claims 1-9, wherein to generate the model for the data center fabric based on the one or more fabric design requirements and the catalog of network devices, the one or more instructions cause the one or more processors to:
generate the model for the data center fabric including:
a plurality of network devices that support the data center fabric; and
a plurality of connections that support the data center fabric.

11. A method performed by the fabric designer system of any of claims 1-10.

12. A computer-readable storage medium encoded with instructions for causing one or more programmable processors to perform a method by the fabric designer system of any of claims 1-10.
